# EUROPEAN PATENT APPLICATION

(11) **EP 4 701 051 A1**
(43) Date of publication of application: **25.02.2026**
(21) Application number: 23933276.0
(22) Date of filing: 19.04.2023
(51) Int. Cl.: H02K 5/00, H02K 11/33, H05K 1/02, H05K 3/46, H05K 7/20, H05K 9/00

(54) **ELECTRONIC CONTROL DEVICE**

(71) Applicant: JTEKT CORPORATION, Kariya-shi, Aichi 448-8652 (JP)
(72) Inventor: MIWA, Yuki, Kariya-shi, Aichi 448-8652 (JP); KOZUKA, Kenichi, Kariya-shi, Aichi 448-8652 (JP)
(74) Representative: Winter, Brandl - Partnerschaft mbB
(86) International application number: PCT/JP2023/015612
(87) International publication number: WO 2024/218898

(57) **Abstract**

An electronic control device (10) includes a board (21) that is configured to be attached to a housing (11) that is made of metal by a fixing member (22) that is made of metal, the board (21) having a plurality of conductor layers (L1 to L6) stacked with an insulating layer (L7) interposed between, and a heat generating element (23) that is configured to generate heat when electric current is applied. The plurality of conductor layers (L1 to L6) includes a first particular conductor layer (L1, L3, L5) that includes an earth layer (E1 to E3) that is configured to be electrically connected to the housing (11), and a second particular conductor layer (L2, L4) that includes a ground layer (G1, G3) that is configured to be electrically connected to the heat generating element (23). The earth layer (E1 to E3) and the ground layer (G1, G3) at least partially face each other in a thickness direction of the board (21) with an insulating layer (L7) interposed between.

## Description

### TECHNICAL FIELD

The present disclosure relates to an electronic control device.

### BACKGROUND ART

Conventionally, there is an electronic control device that is integrally attached to a motor. A controller in Patent Document 1 has a board on which electronic components are provided. The board is attached to a frame at an end portion of the motor in an axial direction thereof, the frame functioning as a heat sink. The electronic components, including heat-generating components such as FETs and so forth, are attached to a front face of the board. A rear face of the board is in contact with the frame.

The board has thermal vias. The thermal vias pass through the board in a thickness direction, directly below the heat-generating components. Heat that is generated from the heat-generating components is transferred from the front face to the rear face of the board through the thermal vias. The heat transferred to the rear face of the board is externally dissipated via the frame.

### Related Art Documents

### Patent Documents

Patent Document 1: Japanese Unexamined Patent Application Publication No. 2019-80471 (JP 2019-80471 A)

### SUMMARY OF THE INVENTION

### Problem to be Solved by the Invention

In recent years, electronic control devices have become smaller in size while at the same time being required to have higher capabilities. Accordingly, mounting density of electronic components on boards is on the rise. As such, there is concern about rise in temperature due to increase in the amount of heat that is generated on the board. Hence, there is demand for improving the heat dissipation capabilities of the board.

### Means for Solving the Problem

An electronic control device according to an aspect of the present disclosure includes a board that is configured to be attached to a housing that is made of metal by a fixing member that is made of metal, the board including a plurality of conductor layers stacked with an insulating layer interposed between, and a heat generating element that is configured to generate heat when electric current is applied. The plurality of conductor layers includes a first particular conductor layer that includes an earth layer that is configured to be electrically connected to the housing, and a second particular conductor layer that includes a ground layer that is configured to be electrically connected to the heat generating element. The earth layer and the ground layer at least partially face each other in a thickness direction of the board with the insulating layer interposed between.

### BRIEF DESCRIPTION OF THE DRAWINGS

[FIG. 1] is a cross-sectional view illustrating a state in which an electronic control device according to an embodiment is attached to an object of control.
[FIG. 2] is a cross-sectional view of the electronic control device in FIG. 1 and surroundings thereof.
[FIG. 3] is a cross-sectional plan view of a first conductor layer in the electronic control device in FIG. 2.
[FIG. 4] is a cross-sectional plan view of a second conductor layer in the electronic control device in FIG. 2.
[FIG. 5] is a cross-sectional plan view of a third conductor layer in the electronic control device in FIG. 2.
[FIG. 6] is a cross-sectional plan view of a fourth conductor layer in the electronic control device in FIG. 2.
[FIG. 7] is a cross-sectional plan view of a fifth conductor layer in the electronic control device in FIG. 2.
[FIG. 8] is a cross-sectional plan view of a sixth conductor layer in the electronic control device in FIG. 2.
[FIG. 9] is a plan view of the first conductor layer in FIG. 3, illustrating a boundary between a first earth layer and a first wiring layer.
[FIG. 10] is a cross-sectional plan view of the second conductor layer in FIG. 4, in which the first earth layer is projected onto a first ground layer.

### MODES FOR CARRYING OUT THE INVENTION

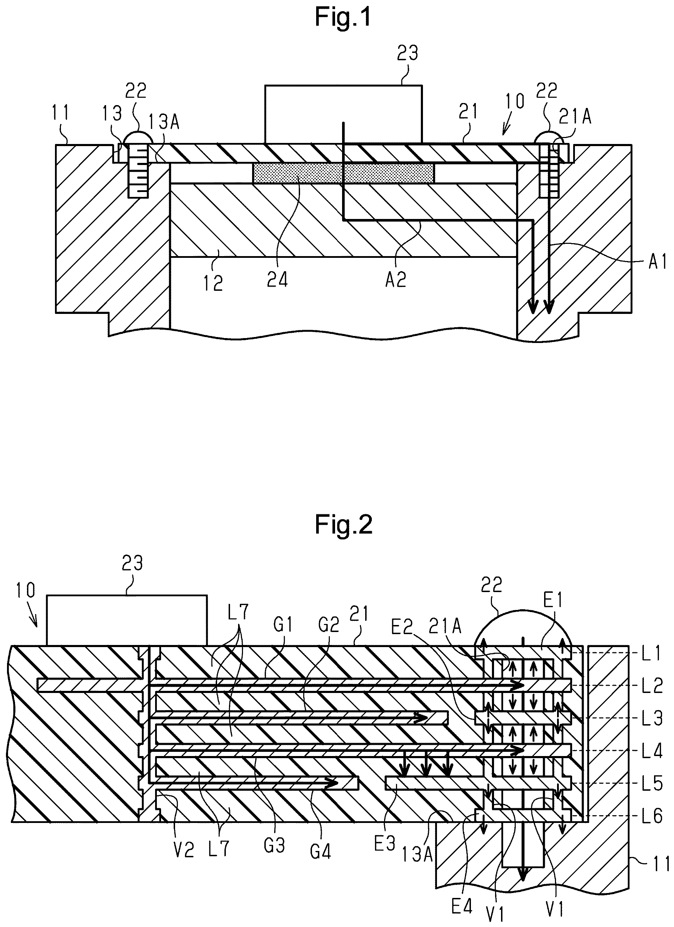

An electronic control device according to an embodiment will be described. The electronic control device is, for example, for vehicular use. As illustrated in FIG. 1, an electronic control device 10 is provided in a housing 11 of an object of control. The object of control is, for example, a motor. The housing 11 is a case for the motor and is, for example, a cylindrical body having a circular cross-sectional shape. An end portion of the housing 11 is open in an axial direction. The end portion, which is open, is an end portion on a side of the housing 11 on which the electronic control device 10 is mounted. An opening portion of the housing 11 is closed off by fitting a lid member 12 thereto. The housing 11 and the lid member 12 are each made of metal. The metal is, for example, iron or an aluminum alloy.

The end portion of the housing 11 has a board accommodating portion 13. The board accommodating portion 13 is located outward from the lid member 12 in the axial direction. The board accommodating portion 13 is a portion at the end portion of the housing 11 of which an inner diameter is enlarged. The board accommodating portion 13 has an attaching portion 13A. The attaching portion 13A has a flat face that spreads in a radial direction of the housing 11. The flat face is an attaching face for a board 21.

The electronic control device 10 has the board 21. The board 21 is accommodated inside of the board accommodating portion 13. The board 21 is in contact with the attaching portion 13A. The board 21 has a flat plate-like shape. The board 21 has one or more through holes 21A provided at a peripheral edge portion thereof. The through hole 21A passes through the board 21 in a thickness direction thereof. The board 21 is fixed to the attaching portion 13A by screws 22. The screws 22 are fixing members for fixing the board 21 to the housing 11. Each of the screws 22 has a shaft portion and a head portion. The shaft portion passes through the through hole 21A and is fastened to the attaching portion 13A. The head portion is in contact with a first face of the board 21.

The board 21 includes the first face and a second face that are located on opposite sides from each other. The first face is the face of the board 21 that is located on an opposite side from the lid member 12. The second face is the face on a side of the board 21 that faces the lid member 12.

Electronic components are provided on the first face. The electronic components include a heat generating element 23 that generates heat when electric current is applied thereto. The heat generating element is a semiconductor element such as an FET (Field Effect Transistor) or the like, for example. A heat dissipation material 24 is interposed between a portion of the second face corresponding to the heat generating element 23 and the lid member 12. The heat dissipation material 24 is, for example, heat dissipation grease. A peripheral edge portion of the second face is in contact with the attaching portion 13A.

### <Heat Dissipation Path>

As indicated by arrows in FIG. 1, heat that is generated by the heat generating element 23 is released, for example, via a first heat dissipation path A1 and a second heat dissipation path A2. The first heat dissipation path A1 and the second heat dissipation path A2 are each heat transfer paths between the heat generating element 23 and the housing 11. The first heat dissipation path A1 includes the board 21, the screw 22, and the housing 11. The second heat dissipation path A2 includes the board 21, the heat dissipation material 24, the lid member 12, and the housing 11. The heat transferred to the housing 11 via the first heat dissipation path A1 and the second heat dissipation path A2 is dissipated externally.

The electronic control device 10 is required to have even higher heat dissipation capabilities. Accordingly, in the present embodiment, the following configuration is adopted as a heat dissipation structure of the electronic control device 10.

### <Heat Dissipation Structure of Electronic Control Device 10>

As illustrated in FIG. 2, the board 21 is a multilayer board. The multilayer board is a board that has three or more conductor layers. The board 21 is, for example, a six-layer board, and has first to sixth conductor layers L1 to L6 that are thin-film-like. The first to sixth conductor layers L1 to L6 are stacked with an insulating layer L7 interposed therebetween. The conductor making up the conductor layers is, for example, copper. Copper has excellent electrical conductivity and thermal conductivity as compared to, for example, resin. The insulating layer L7 is formed of a core material or a prepreg. The core material and the prepreg are each layers of glass fiber that is impregnated with resin.

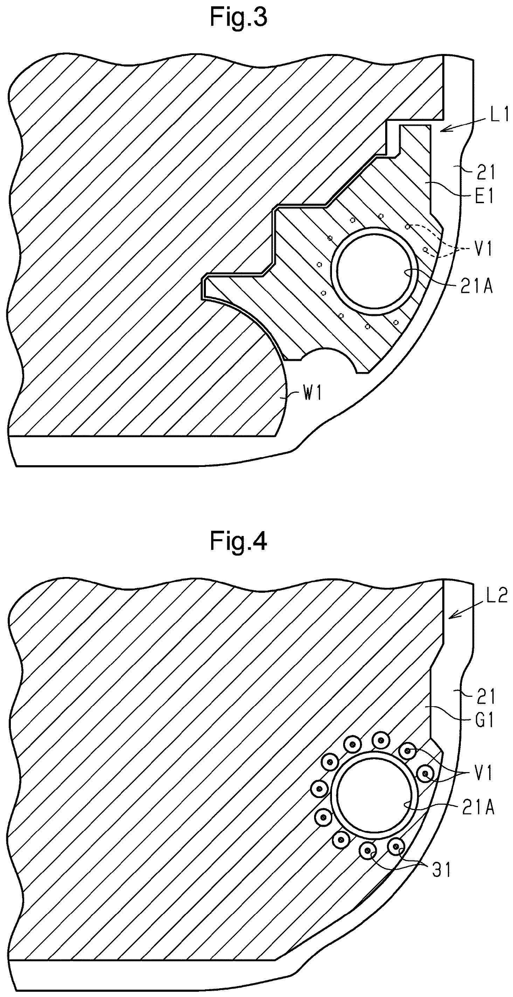

As illustrated in FIG. 2, the first to sixth conductor layers L1 to L6 are arranged in this order from the first face to the second face of the board 21. The first conductor layer L1 has a first earth layer E1. The first earth layer E1 is provided around the through hole 21A. A portion of the board 21 around the through hole 21A corresponds to a portion of the board 21 that comes into contact with the housing 11. The portion of the board 21 that comes into contact with the housing 11 is a portion of the board 21 that corresponds to the attaching portion 13A. That is to say, the board 21 has a contact portion that contacts the housing 11, and the contact portion is a portion that overlaps the attaching portion 13A as viewed in the thickness direction of the board 21. The first earth layer E1 is exposed on the first face of the board 21 and is in contact with the head portion of the screw 22. That is to say, the first earth layer E1 is electrically connected to the housing 11 via the screw 22. As illustrated in FIG. 3, the first conductor layer L1 also includes, for example, a first wiring layer W1. The first wiring layer W1 is provided with pattern wiring. A minute gap is formed at a boundary between the first earth layer E1 and the first wiring layer W1. Note that for convenience of description, the first wiring layer W1 is omitted from illustration in FIG. 2.

As illustrated in FIG. 2, the second conductor layer L2 has a first ground layer G1. The first ground layer G1 extends from a portion of the board 21 corresponding to the heat generating element 23, to the through hole 21A. A part of the first ground layer G1 faces the first earth layer E1 in the thickness direction of the board 21, with the insulating layer L7 interposed therebetween. The part of the first ground layer G1 facing the first earth layer E1 is the portion of the first ground layer G1 around the through hole 21. As illustrated in FIG. 4, the first ground layer G1 has a plurality of first holes 31. The first holes 31 are disposed so as to surround the through hole 21A. The first holes 31 are through holes that pass through the first ground layer G1 in a film thickness direction.

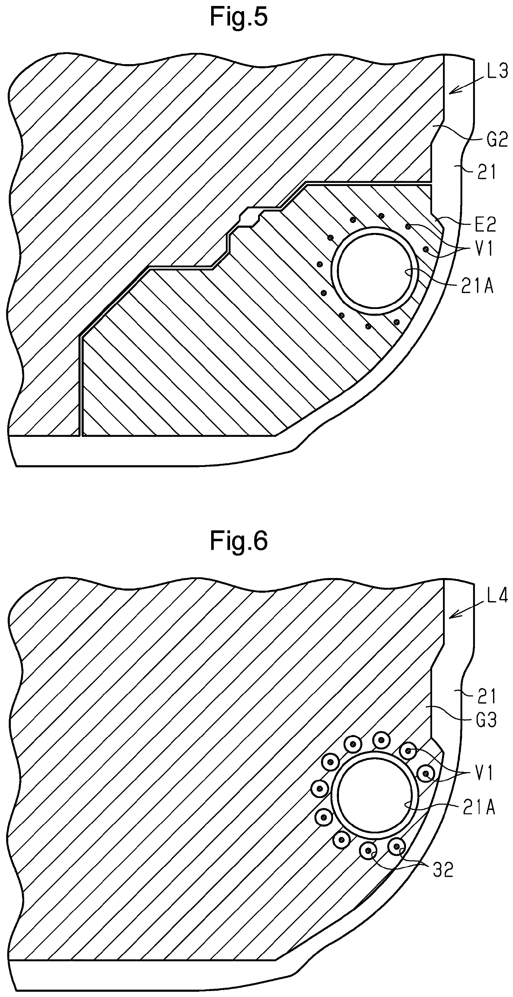

As illustrated in FIG. 2, the third conductor layer L3 has a second earth layer E2 and a second ground layer G2. The second earth layer E2 is provided around the through hole 21A. The second earth layer E2 faces a part of the first ground layer G1 in the thickness direction of the board 21 with the insulating layer L7 interposed therebetween. The part of the first ground layer G1 facing the second earth layer E2 is the portion of the first ground layer G1 around the through hole 21. The second ground layer G2 extends from the portion of the board 21 corresponding to the heat generating element 23 to the vicinity of the second earth layer E2. As illustrated in FIG. 5, a minute gap is formed at a boundary between the second earth layer E2 and the second ground layer G2.

As illustrated in FIG. 2, the fourth conductor layer L4 has a third ground layer G3. The third ground layer G3 extends from the portion of the board 21 corresponding to the heat generating element 23 to the through hole 21A. A part of the third ground layer G3 faces the second earth layer E2 in the thickness direction of the board 21, with the insulating layer L7 interposed therebetween. The part of the third ground layer G3 facing the second earth layer E2 is the portion of the third ground layer G3 around the through hole 21. As illustrated in FIG. 6, the third ground layer G3 has a plurality of second holes 32. The second holes 32 are the same in number as the first holes 31, and are arranged so as to surround the through hole 21A. The second holes 32 are through holes that pass through the third ground layer G3 in the film thickness direction. The second holes 32 are disposed coaxially with the first holes 31.

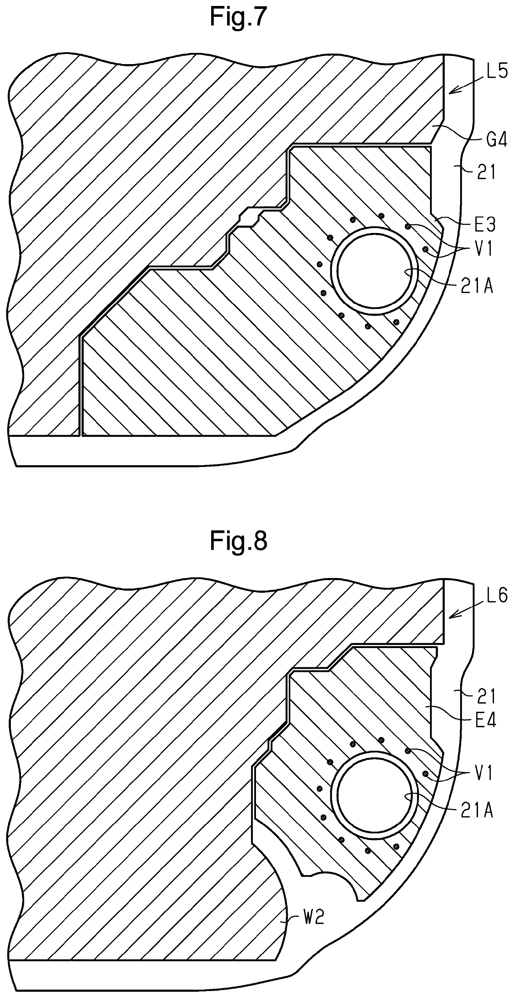

As illustrated in FIG. 2, the fifth conductor layer L5 has a third earth layer E3 and a fourth ground layer G4. The third earth layer E3 is provided around the through hole 21A. The third earth layer E3 extends from a peripheral edge portion of the through hole 21A outward in a radial direction from the through hole 21A. The third earth layer E3 spreads to a position away from the portion of the board 21 that comes into contact with the housing 11. The third earth layer E3 faces a part of the third ground layer G3 in the thickness direction of the board 21 with the insulating layer L7 interposed therebetween. The part of the third ground layer G3 facing the third earth layer E3 includes the portion of the third ground layer G3 around the through hole 21. The fourth ground layer G2 extends from a portion of the board 21 corresponding to the heat generating element 23 to the vicinity of the third earth layer E3. As illustrated in FIG. 7, a minute gap is formed at a boundary between the third earth layer E3 and the fourth ground layer G4.

As illustrated in FIG. 2, the sixth conductor layer L6 includes a fourth earth layer E4. The fourth earth layer E4 is provided around the through hole 21A. The fourth earth layer E4 is exposed on the second face of the board 21 and is in contact with the attaching portion 13A. That is to say, the fourth earth layer E4 is electrically connected to the housing 11. As illustrated in FIG. 8, the sixth conductor layer L6 also includes, for example, a second wiring layer W2. The second wiring layer W2 is provided with pattern wiring. A minute gap is formed at a boundary between the fourth earth layer E4 and the second wiring layer W2. Note that for convenience of description, the second wiring layer W2 is omitted from illustration in FIG. 2.

The board 21 has a plurality of first thermal vias V1. The number of first thermal vias V1 is the same as the number of first holes 31 and the second holes 32. The first thermal vias V1 are formed by driving a metal body such as copper or the like, for example, having excellent thermal conductivity, into the board 21. The first thermal vias V1 have, for example, a circular cross-sectional shape. The first thermal vias V1 are disposed on the peripheral edge portion of the through hole 21A. The first thermal vias V1 extend in the thickness direction of the board 21 and link the first to fourth earth layers E1 to E4 to each other. The first thermal vias V1 are electrically connected to the first to fourth earth layers E1 to E4, but are electrically insulated from the first to fourth ground layers G1 to G4.

That is to say, as illustrated in FIGS. 3, 5, 7 and 8, the first thermal vias V1 pass through the board 21 in the thickness direction while being in contact with the first to fourth earth layers E1 to E4. Outer peripheral faces of the first thermal vias V1 come into contact with each of the first to fourth earth layers E1 to E4, thereby ensuring electrical connection between the first thermal vias V1 and the first to fourth earth layers E1 to E4.

As illustrated in FIG. 4, the first thermal vias V1 pass through the board 21 in the thickness direction in a contactless state with the first ground layer G1 that has a portion surrounding the through hole 21A. The first holes 31 are larger than the outside diameters of the first thermal vias V1. Gaps are formed between inner peripheral faces of the first holes 31 and the outer peripheral faces of the first thermal vias V1. The gaps ensure electrical insulation between the first thermal vias V1 and the first ground layer G1.

As illustrated in FIG. 6, the first thermal vias V1 pass through the board 21 in the thickness direction in a contactless state with the third ground layer G3 that has a portion surrounding the through hole 21A. The second holes 32 are larger than the outside diameters of the first thermal vias V1. Gaps are formed between inner peripheral faces of the second holes 32 and the outer peripheral faces of the first thermal vias V1. The gaps ensure electrical insulation between the first thermal vias V1 and the third ground layer G3.

The second ground layer G2 and the fourth ground layer G4 do not have a portion surrounding the through hole 21A. That is to say, when viewed in the thickness direction of the board 21, the second ground layer G2 and the fourth ground layer G4 do not overlap the first thermal vias V1. The second ground layer G2 is not in contact with the first thermal vias V1, and accordingly electrical insulation between the first thermal vias V1 and the second ground layer G2 is ensured. Also, the fourth ground layer G4 is not in contact with the first thermal vias V1, and accordingly electrical insulation between the first thermal vias V1 and the fourth ground layer G4 is ensured.

The board 21 has second thermal vias V2. The second thermal vias V2 are formed by driving a metal body such as copper or the like, for example, having excellent thermal conductivity, into the board 21. The second thermal vias V2 have, for example, a circular cross-sectional shape. The second thermal vias V2 are disposed in a portion of the board 21 corresponding to the heat generating element 23. The second thermal vias V2 extend in the thickness direction of the board 21 and link the first to fourth ground layers G1 to G4 to each other. First end portions of the second thermal vias V2 are exposed on the first face of the board 21 and are in contact with the heat generating element 23. That is to say, the first to fourth ground layers G1 to G4 are electrically connected to the heat generating element 23 through the second thermal vias V2. Second end portions of the second thermal vias V2 are exposed on the second face of the board 21. The second end portions are end portions of the second thermal vias V2 on the side opposite to the first end portions.

As indicated by the arrows in FIG. 2, heat that is generated from the heat generating element 23 is transferred to the housing 11 via the second thermal vias V2, the first to fourth ground layers G1 to G4, the first to fourth earth layers E1 to E4, the first thermal vias V1, and the screw 22. Part of the heat is transferred between the ground layers (G1 to G4) and the earth layers (E1 to E4) which face each other in the thickness direction of the board 21 with the insulating layer L7 interposed therebetween. Part of the heat is transferred to the housing 11 via the first earth layer E1 and the screw 22. Part of the heat is transferred to the housing 11 via the fourth earth layer E4. Part of the heat is transferred to the housing 11 through the second thermal vias V2, the heat dissipation material 24, and the lid member 12. Note, however, in FIG. 2, the heat dissipation material 24 and the lid member 12 are omitted from illustration. The heat that is transferred to the housing 11 is externally dissipated.

### <Thermal Resistance Between Two Layers>

Thermal resistance in thermal conduction is proportional to the length of an object and inversely proportional to the cross-sectional area of the object. That is to say, the shorter the length of an object is, and the larger the cross-sectional area of the object is, the smaller the thermal resistance in thermal conduction will be. Thermal resistance in thermal radiation is inversely proportional to the surface area of an object. That is to say, the larger the surface area of an object is, the smaller the thermal resistance to thermal radiation will be.

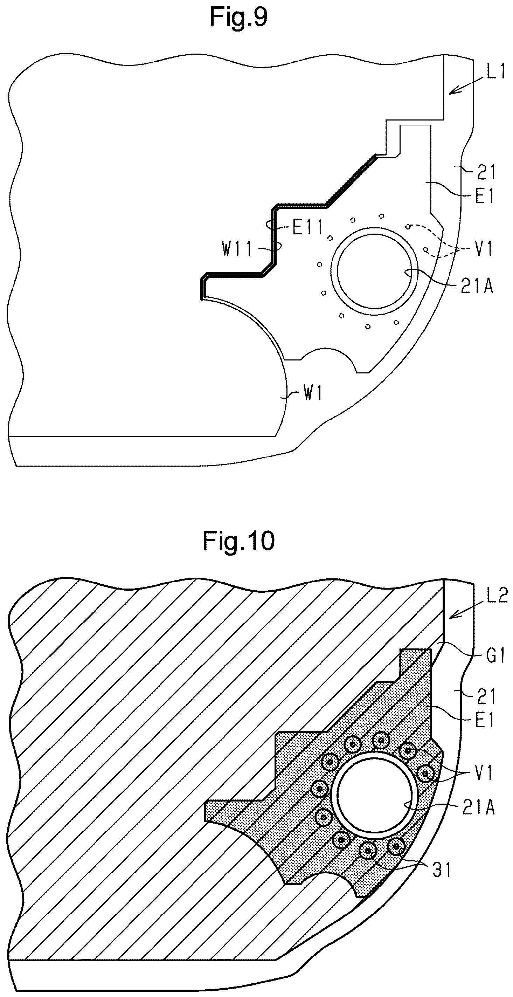

As illustrated in FIG. 9, in the first conductor layer L1 for example, the first earth layer E1 has a first counterface E11. The first counterface E11 is a part of a peripheral edge of the first earth layer E1. The first wiring layer W1 has a second counterface W11. The second counterface W11 is a part of a peripheral edge of the first wiring layer W1, and has a contour shape corresponding to the first counterface E11. The first counterface E11 and the second counterface W11 face each other with a constant minute gap therebetween. The distance between the first counterface E11 and the second counterface W11 is smaller than the distance among the first to sixth conductor layers L1 to L6 in the thickness direction.

A counterface area between the first counterface E11 and the second counterface W11 is extremely small as compared to a counterface area between the first earth layer E1, indicated by a great number of dots in FIG. 10, and the first ground layer G1 in the second conductor layer L2. This is because the thickness of the first conductor layer L1 including the first earth layer E1 and the first wiring layer W1 is extremely thin. Accordingly, overall, the thermal resistance between the first counterface E11 and the second counterface W11 is greater than the thermal resistance between the first earth layer E1 and the first ground layer G1. The same can be said for each of the first to sixth conductor layers L1 to L6.

Thus, the thermal resistance between two layers facing each other in the thickness direction of the board 21 with the insulating layer L7 interposed therebetween is smaller than the thermal resistance between two layers that are adjacent to each other, and that are located on the same plane. In the thickness direction of the board 21, the thermal resistance between two layers facing each other with the insulating layer L7 interposed therebetween is smaller the greater the counterface area of these two layers is, and also is smaller the thinner the thickness of the insulating layer L7 is.

### <Effects of Embodiment>

The present embodiment has the following effects.
(1) The board 21 has a plurality of conductor layers (L1 to L6) that are stacked with an insulating layer L7 interposed therebetween. The plurality of conductor layers includes a first particular conductor layer having an earth layer that is configured to be electrically connected to the housing 11, and a second particular conductor layer having a ground layer that is configured to be electrically connected to the heat generating element 23.

The first particular conductor layer is the first conductor layer L1, the third conductor layer L3, or the fifth conductor layer L5. The first conductor layer L1 has the first earth layer E1, the third conductor layer L3 has the second earth layer E2, and the fifth conductor layer L5 has the third earth layer E3. The first to third earth layers E1 to E3 are each configured to be electrically connected to the housing 11.

The second particular conductor layer is the second conductor layer L2 or the fourth conductor layer L4. The second conductor layer L2 has the first ground layer G1, and the fourth conductor layer L4 has the third ground layer G3. The first ground layer G1 and the third ground layer G3 are each configured to be electrically connected to the heat generating element 23.

With the first particular conductor layer as the first conductor layer L1, the second particular conductor layer is the second conductor layer L2. The first earth layer E1 and the first ground layer G1 at least partially face each other in the thickness direction of the board 21 with the insulating layer L7 interposed therebetween.

With the first particular conductor layer as the third conductor layer L3, the second particular conductor layer is the second conductor layer L2 or the fourth conductor layer L4. The third conductor layer L3 and the first ground layer G1, or the third conductor layer L3 and the third ground layer G3, at least partially face each other in the thickness direction of the board 21 with the insulating layer L7 interposed therebetween.

With the first particular conductor layer as the fifth conductor layer L5, the second particular conductor layer is the fourth conductor layer L4. The third earth layer E3 and the third ground layer G3 at least partially face each other in the thickness direction of the board 21 with the insulating layer L7 interposed therebetween.

According to this configuration, the heat that is generated by the heat generating element 23 is transferred to the housing 11 via the ground layers (G1 to G4), the earth layers (E1 to E4), and the screws 22. The heat that is transferred to the housing 11 is externally dissipated. Heat is transferred between the portions at which the earth layers (E1 to E3) and the ground layers (G1, G3) face each other in the thickness direction of the board 21 with the insulating layer L7 interposed therebetween. The heat dissipation capabilities of the board 21 are improved as compared to a case in which the earth layers (E1 to E3) and the ground layers (G1, G3) do not face each other in the thickness direction of the board 21 with the insulating layer L7 interposed therebetween.

(2) The earth layers (E1 to E3) and the ground layers (G1, G3) at least partially overlap in the thickness direction of the board 21 in the region at which the board 21 comes into contact with the housing 11. The portion of the board 21 that comes into contact with the housing 11 is a portion of the board 21 that corresponds to the attaching portion 13A. According to this configuration, the distance from the ground layers (G1, G3) to the housing 11 is even shorter. Due to the thermal resistance between the ground layers (G1, G3) and the housing 11 being smaller, the heat dissipation capabilities of the board 21 are improved.

(3) There are a plurality of sets of the first particular conductor layer and the second particular conductor layer. The plurality of sets includes, for example, a first set that is made up of the first conductor layer L1 and the second conductor layer L2, and a second set that is made up of the third conductor layer L3 and the fourth conductor layer L4. The first earth layer E1, the first ground layer G1, the second earth layer E2, and the third ground layer G3 are arranged in this order in the thickness direction of the board 21. That is to say, the earth layers (E1, E2) and the ground layers (G1, G3) are alternately arranged in the thickness direction of the board 21. According to this configuration, the area in which the earth layers and the ground layers face each other in the thickness direction of the board 21 with the insulating layer L7 interposed therebetween can be increased in the board 21 overall. Thus, the heat dissipation capabilities of the board 21 are improved.

(4) The board 21 has the plurality of first thermal vias V1 that links a plurality of the earth layers (E1 to E4) to each other. The first thermal vias V1 are interlayer conductors that link the earth layers of conductor layers that are different from each other. According to this configuration, transfer of heat is performed among the plurality of earth layers (E1 to E4) through the first thermal vias V1. Thus, the heat dissipation capabilities of the board 21 are improved.

(5) The first ground layer G1 and the third ground layer G3 each have the holes 31. The first thermal vias V1 extend through the holes 31 in a contactless state with each of the ground layers G1 and G3. According to this configuration, area in which the earth layers (E1 to E3) and the ground layers (G1, G3) face each other in the thickness direction of the board 21 can be secured with the insulating layer L7 interposed therebetween, while the earth layers (E1 to E3) and the ground layers (G1, G3) can be electrically insulated from each other.

(6) The board 21 has the contact portion that comes into contact with the housing 11. At least one (E3) of the plurality of earth layers (E1 to E4) faces a part of the ground layer (G3) in the thickness direction of the board 21 with the insulating layer L7 interposed therebetween at a position corresponding to the contact portion of the board 21 and at a position away from the contact portion. According to this configuration, the area in which the earth layer (E3) and the ground layer (G3) face each other in the thickness direction of the board 21, with the insulating layer L7 interposed therebetween, is increased. Thus, the heat dissipation capabilities of the board 21 can be improved.

### <Other Embodiments>

The present embodiment may be carried out modified as follows.
- In a case in which the heat dissipation capabilities required of the board 21 can be ensured, the heat dissipation material 24 between the board 21 and the lid member 12 may be omitted.
- The heat generating element 23 may be provided on the second face of the board 21. In this case, the heat dissipation material 24 is interposed between the heat generating element 23 and the lid member 12.
- The board 21 may be fixed to the housing 11 by pins, for example, instead of the screws 22. The pins are fixing members for fixing the board 21 to the housing 11.
- The first thermal vias V1 may be singular.
- The earth layer that faces a part of the ground layer in the thickness direction of the board 21 with the insulating layer L7 interposed therebetween at a position corresponding to the contact portion of the board 21 and at a position away from the contact portion is not limited to the third earth layer E3. The earth layer that spreads to a position away from the contact portion of the board 21 is determined by product specifications. At least one of the first to fourth earth layers E1 to E4 may spread to a position away from the contact portion of the board 21. The extent to which the earth layer spreads is also determined by product specifications.
- The board 21 is not limited to a six-layer board having the first to sixth conductor layers L1 to L6. The board 21 may be, for example, a three-layer board or a four-layer board.
- The earth layers (E1 to E3) and the ground layers (G1, G3) do not have to be arranged alternately in the thickness direction of the board 21. For example, the first earth layer E1, the first ground layer G1, the third ground layer G3, and the second earth layer E2 may be arranged in this order in the thickness direction of the board 21.
- The electronic control device 10 is not limited to vehicular use. The electronic control device 10 can be used to control a variety of mechanical devices.
- The expression "at least one" as used in the present specification means "one or more" of desired options. As one example, when the number of options is two, the expression "at least one" as used in the present specification means "only one of the options" or "both of the two options". As another example, when the number of options is three or more, the expression "at least one" as used in the present specification means "only one option" or "any combination of two or more options".

## Claims

1. An electronic control device comprising:
a board that is configured to be attached to a housing that is made of metal by a fixing member that is made of metal, the board including a plurality of conductor layers stacked with an insulating layer interposed between; and
a heat generating element that is configured to generate heat when electric current is applied, wherein
the plurality of conductor layers includes
a first particular conductor layer that includes an earth layer that is configured to be electrically connected to the housing, and
a second particular conductor layer that includes a ground layer that is configured to be electrically connected to the heat generating element, and
the earth layer and the ground layer at least partially face each other in a thickness direction of the board with the insulating layer interposed between.

2. The electronic control device according to claim 1, wherein the earth layer and the ground layer at least partially overlap in the thickness direction of the board in a region in which the board comes into contact with the housing.

3. The electronic control device according to claim 1 or 2, wherein
a plurality of sets of the first particular conductor layer and the second particular conductor layer is present, and
a plurality of the earth layers and a plurality of the ground layers are alternately arranged in the thickness direction of the board.

4. The electronic control device according to claim 3, wherein the board has a singular or a plurality of interlayer conductors linking a plurality of the earth layers to each other.

5. The electronic control device according to claim 4, wherein the ground layer has a through hole, and the interlayer conductor extends through the through hole in a contactless state with the ground layer.

6. The electronic control device according to claim 3, wherein
the board has a contact portion that comes into contact with the housing, and
at least one of the plurality of the earth layers faces a part of the ground layer with the insulating layer interposed between, in the thickness direction of the board at a position corresponding to the contact portion and at a position away from the contact portion.
